Europäisches Patentamt

European Patent Office

Office européen des brevets

(19)

(11) Numéro de publication : **0 306 412 B1**

(12)

# FASCICULE DE BREVET EUROPEEN

(45) Date de publication du fascicule du brevet :
**22.04.92 Bulletin 92/17**

(51) Int. Cl.⁵ : **H05K 7/20**

(21) Numéro de dépôt : **88402213.8**

(22) Date de dépôt : **02.09.88**

(54) **Boîtier pour circuit électronique.**

(30) Priorité : **03.09.87 FR 8712241**

(43) Date de publication de la demande :
**08.03.89 Bulletin 89/10**

(45) Mention de la délivrance du brevet :
**22.04.92 Bulletin 92/17**

(84) Etats contractants désignés :
**DE GB IT SE**

(56) Documents cités :
**EP-A- 0 078 684**
**EP-A- 0 113 073**
**EP-A- 0 178 977**
**WO-A-87/01007**
**US-A- 3 972 062**

(73) Titulaire : **Siemens Automotive S.A.**
**Avenue du Mirail, B.P. 1149**
**F-31036 Toulouse Cédex (FR)**

(72) Inventeur : **Boucard, Michel**
**20 rue des Biches**
**F-31170 Tournefeuille (FR)**
Inventeur : **Thirion, Christian**
**33 avenue Justin Pages**
**F-31190 Auterive (FR)**
Inventeur : **Maurel, Christian**
**7 rue du Château Perpin**
**F-31500 Toulouse (FR)**

(74) Mandataire : **Fuchs, Franz-Josef, Dr.-Ing. et al**
**Postfach 22 13 17**
**W-8000 München 22 (DE)**

EP 0 306 412 B1

Jouve, 18, rue Saint-Denis, 75001 PARIS

## Description

La présente invention est relative à un boîtier pour circuit électronique et, plus particulièrement, à un tel boîtier conçu pour recevoir au moins un composant électronique de puissance.

On utilise couramment aujourd'hui des dispositifs électroniques comportant une partie dite "de puissance" où des courants électriques d'intensité substantielle provoquent dans les composants qu'ils traversent un dégagement de chaleur tel qu'il convient de prévoir des moyens d'évacuation de cette énergie thermique. Les composants actifs comportant des électrodes traversées par ces courants, telles que le collecteur d'un transistor de puissance par exemple, sont particulièrement sensibles à une élévation de température et il convient d'assurer leur refroidissement pour que leurs caractéristiques de fonctionnement n'en soient pas affectées.

Pour ce faire, on soude couramment sur le collecteur d'un transistor de puissance une plaquette métallique de plus grande surface, en cuivre par exemple, pour accroître le rayonnement thermique, cette plaquette pouvant elle-même être électriquement reliée à une broche de connexion extérieure par un fil soudé à ses deux extrémités, ou par une piste conductrice gravée ou déposée et des soudures aux extrémités de cette piste. La plaquette elle-même peut être fixée sur un substrat en céramique par exemple, électriquement isolant mais néanmoins de faible résistance thermique, ce substrat étant lui-même en contact thermique avec un puits de chaleur. On décrit un boîtier comprenant un tel agencement de plaquettes et de soudures ou liaisons dans FR-A- 2 570 877. EP-A- 0078 684 et US-A- 3 972 062 décrivent d'autres boîtiers ou montages de composants de puissance dans lesquels une électrode est agencée de manière à remplir à la fois une fonction thermique et une fonction électrique.

Ces boîtiers connus comprennent un nombre élevé de soudures ou autres liaisons qui rendent plus difficiles les transferts thermiques nécessaires au refroidissement du composant de puissance, tout en compliquant le montage et en diminuant par là sa fiabilité. En outre, ils ne sont pas adaptés à la réception de plus d'un composant de puissance ni à la réception simultanée d'autres composants actifs ou passifs, comme on en trouve maintenant couramment dans de nombreux circuits électroniques tels que des circuits de commande d'actuateurs comprenant une section de calcul et une section de puissance. A titre d'exemple non limitatif d'applications de circuits de ce type, on peut citer la commande d'une bobine d'allumage de moteur à combustion interne.

La présente invention a donc pour but de réaliser un boîtier pour circuit électronique comprenant au moins un composant de puissance, ce boîtier étant équipé de moyens à fonctions thermique et électrique assurant, avec un nombre minimal de soudures ou autres liaisons, le refroidissement du composant par l'intermédiaire d'une de ses éléctrodes et la liaison électrique de cette électrode à une broche de connexion extérieure du boîtier.

La présente invention a aussi pour but de réaliser un tel boîtier conçu pour recevoir, outre des composants de puissance associés à ces moyens à fonction thermique et électronique, d'autres composants pouvant être montés de manière classique et reliés à d'autres broches de connexion extérieure du boîtier.

On atteint ces buts de l'invention avec un boîtier pour circuit électronique comprenant au moins un composant électronique de puissance, muni d'au moins un radiateur métallique présentant une surface agencée pour être en contact thermique et électrique avec une électrode du composant, caractérisé en ce que ladite surface du radiateur affleure sur une face d'une paroi interne du boîtier alors que les autres faces du radiateur sont noyées dans cette paroi, et en ce qu'une broche de connexion électrique est formée d'une pièce avec le radiateur, cette broche s'étendant dans l'épaisseur d'au moins ladite paroi du boîtier pour sortir de celui-ci dans une position de connexion extérieure.

Grâce au radiateur à broche de connexion intégrée du boîtier suivant l'invention, on donne à ce radiateur une double fonction thermique et électrique au prix d'un nombre minimal de soudures ou autres liaisons, comme on l'expliquera dans la suite en liaison avec l'examen du dessin annexé dans lequel :

    – la figure 1 est une vue partielle, en perspective et en coupe, d'un boîtier pour circuit électronique suivant l'invention ;

    – la figure 2 est une vue partielle, en coupe, d'un autre mode de réalisation du boîtier suivant l'invention 1 et ;

    – la figure 3 est une vue en perspective d'un mode de réalisation particulier d'un radiateur à broche de connexion intégrée conçu pour équiper un boîtier suivant l'invention.

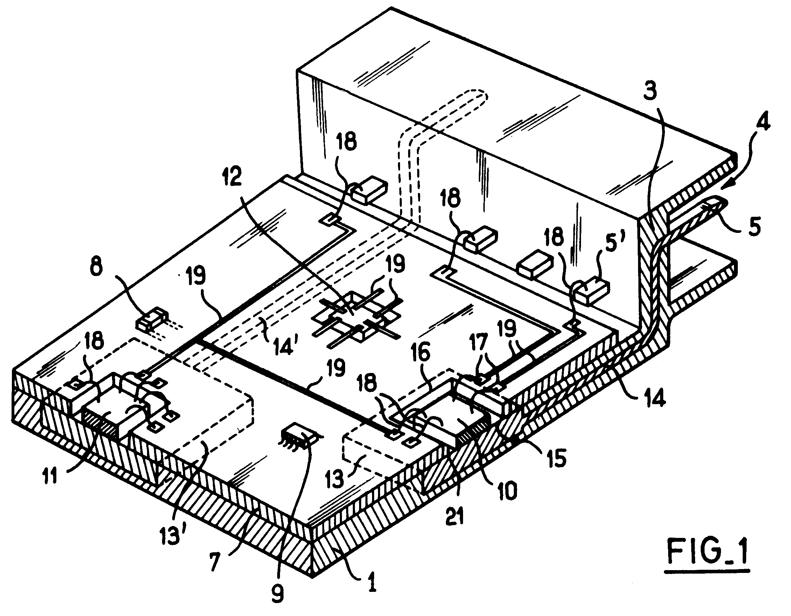

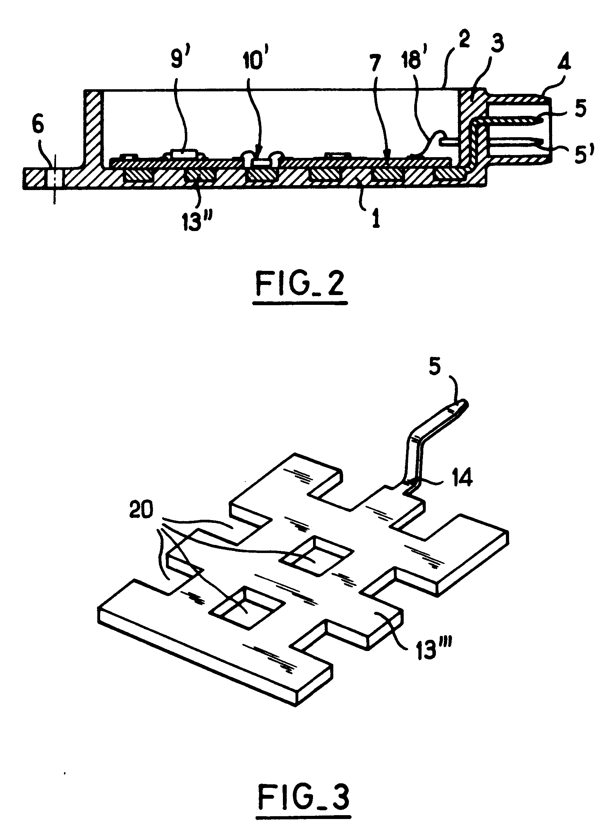

On se réfère tout d'abord à la figure 1 qui fait apparaitre une partie du fond 1 du boîtier suivant l'invention limitée par deux plans de coupe orthogonaux, ce fond étant du même type que celui du boîtier représenté plus complètement à la figure 2. Une même référence numérique, éventuellement indicée, repère aux figures des éléments ou organes identiques ou semblables. Le fond 1 est fermé hermétiquement par un couvercle (non représenté) fixé sur une ouverture supérieure 2 du fond (voir figure 2). D'une paroi latérale 3 du fond 1 déborde un logement 4 conçu pour protéger des groupes de broches de connexion électriques 5, 5′ agencées par exemple en deux lignes parallèles. Ce logement est dimensionné de manière à recevoir complémentairement un connecteur (non représenté) qui établit une liaison entre un circuit électronique contenu dans le boîtier et des organes ou appareils extérieurs qui échangent des signaux électriques avec le circuit que le boîtier a pour fonction de protéger de dégradations éventuelles résultant d'influences extérieures (humidité, température, poussières, etc.). Des trous tels que représentés en 6 (Fig 2) sont percés dans une extension du fond du boîtier. Ces trous sont destinés à être traversés par des organes de fixation tels que des vis, pour la fixation du boîtier sur un support, en position d'utilisation. Toutes ces dispositions sont courantes et ne seront donc pas décrites plus avant.

Classiquement encore, un substrat 7 propre à recevoir des composants du circuit électronique est fixé sur le fond du boîtier. Ce substrat peut être réalisé en alumine ou en céramique, par exemple, et présenter une structure multi-couches avec couches conductrices et pistes conductrices comme il est bien connu.

Des composants passifs ou actifs de tous types sont montés sur ce substrat conformément à l'organisation particulière du circuit, visant à lui faire exécuter telle ou telle fonction. Les composants passifs peuvent être des résistances, condensateurs ou selfs classiques ou du type à montage en surface, par exemple. Les composants actifs peuvent être constitués par des composants discrets ou intégrés, sous forme de puces nues ou en boîtiers de divers types connus. A titre d'exemple on a représenté sur le substrat du circuit contenu dans le boîtier de la figure 1, une résistance 8 à montage en surface et un circuit intégré 9 en boîtier pour montage en surface. Le circuit comprend encore des composants de puissance 10, 11, 12 dont le montage tire parti de la structure du boîtier suivant l'invention, comme on l'explique en plus de détail dans la suite.

Le composant schématisé en 10 sous forme d'une "puce" sur la figure 1 peut être, à titre d'exemple non limitatif, un composant de puissance "intelligent" comprenant une électrode de puissance placée à la face inférieure 21 du composant (du point de vue de la figure 1). Cette électrode voit passer des courants relativement forts générateurs d'un effet Joule tel qu'une évacuation de la chaleur dégagée doit être organisée. En outre, le courant doit être transmis à l'extérieur du boîtier vers un appareil d'utilisation tel qu'un actuateur commandé par ce courant.

Pour ce faire, le boîtier suivant la présente invention comprend un radiateur 13 métallique formé d'une pièce avec une partie allongée 14 constituant une broche de connexion dont l'extrémité 5 déborde du boîtier dans le logement 4, la plus grande partie de la partie allongée 14 étant noyée dans la matière constituant le fond du boîtier 1. La surface supérieure 15 du radiateur 13 est beaucoup plus importante que celle de l'électrode formée sur la face 21 du composant 10, pour offrir aux calories une surface de dissipation plus grande qui accroît la vitesse d'évacuation de ces calories.

Suivant une caractéristique du boîtier de l'invention, cette surface supérieure 15 affleure à la surface du fond du boîtier. Il apparait en outre sur la figure 1 que le substrat 7 est découpé, en face du radiateur 13, d'une fenêtre 16 qui autorise le montage du composant 10 sur le radiateur. Ce montage est réalisé par soudure de l'électrode de puissance du composant 10 sur le radiateur 13, la zone de contact de la surface 15 du radiateur étant préalablement métallisée (à l'argent par exemple) pour faciliter la soudure.

On remarque qu'il n'y a ainsi qu'une seule soudure entre cette électrode et la broche de connexion 5 associée. Cette caractéristique du boîtier suivant l'invention apporte plusieurs avantages. Tout d'abord, elle accélère le montage du composant. Elle accroît la fiabilité des connexions électriques, qui décroît avec le nombre de soudures, éventuellement défaillantes, des boîtiers de la technique antérieure. Elle diminue corrélativement les prix de revient de fabrication.

L'affleurement du radiateur 13 sur le fond du boîtier suivant l'invention facilite le montage dans ce boîtier du circuit sur substrat 7 et du composant 10 lui-même, par des machines automatiques utilisées dans les fabrication de boîtiers électroniques en grandes séries, pour l'industrie automobile par exemple.

En dehors de l'électrode de puissance formant partie du composant 10, d'autres électrodes de ce composant qui ne posent pas de problème thermique peuvent être connectées dans le circuit, ou aux broches de connexion 5', par des moyens classiques, plots de contact 17, fils soudés 18 et pistes conductrices 19, comme représenté à la figure 1 à titre d'exemple.

Suivant l'invention, le boîtier peut comprendre plusieurs composants de puissance 10, 11, 12 montés chacun sur un radiateur associé, comme l'est le composant 10. Incidemment, la connexion entre les pistes 19 du substrat 7 et les électrodes du composant peut être directe, comme représenté pour le composant 12 à la figure 1. L'agencement des divers radiateurs 13, 13',... noyés dans le boîtier avec les parties allongées 14, 14',... associées, doit alors faire l'objet d'une étude particulière d'encombrement et d'imbrication.

Le fond du boîtier suivant l'invention peut être réalisé de préférence par moulage par injection. Plus précisément, on fixe alors les radiateurs contre le fond d'un moule à l'aide de plots de maintien, dans des positions prédéterminées correspondant à celles des surfaces 15 de ces radiateurs sur le fond du boîtier à obtenir, et on utilise ensuite la technique du double moulage pour fixer les radiateurs en position et remplir ensuite les emplacements occupés par des plots de maintien, après retrait de ceux-ci.

Divers matériaux thermoplastiques ou thermodurcisables peuvent être utilisés pour les injections, au choix de l'homme de métier. On pourra par exemple choisir les produits vendus sous les dénominations RYTON®, VALOX® 420, RINITE® 530, commercialisés par les Sociétés dites Phillips Petroleum, General Electric, Du Pont de Nemours, respectivement.

Les radiateurs incorporés au boîtier suivant l'invention peuvent prendre la forme d'une plaquette pleine généralement rectangulaire. Cette forme peut cependant subir diverses modifications en vue de l'adapter à des besoins précis. Par exemple, si la surface du radiateur doit être relativement grande pour assurer une bonne dissipation thermique, on pourra donner à ce radiateur la configuration d'une grille 13″,13‴ comme représenté aux figures 2, 3 respectivement de manière à permettre l'injection de la matière constituant le boîtier dans des jours 20 de la grille (voir figure 3). On assure ainsi la bonne tenue du radiateur dans l'épaisseur du boîtier, même avec de faibles épaisseurs de matière. Le radiateur à broche de connexion intégrée du boîtier suivant l'invention peut ainsi assurer une fonction de tenue mécanique du boîtier, par l'armature métallique qu'il fournit, en plus de ses fonctions thermique et électrique décrites ci-dessus. La fixation du radiateur dans l'épaisseur du boîtier peut encore être renforcée par des enfoncements (non représentés) qui déforment le radiateur dans son épaisseur.

Le boîtier suivant l'invention trouve application à la protection d'un circuit électronique comportant une section de puissance exigeant un refroidissement de certains composants au niveau d'une électrode de ces composants. Il se prête à une fabrication automatisée en grande série et autorise aussi l'insertion automatisée des composants de puissance dans le boîtier, comme cela est exigé dans la fabrication de circuits de commande de moteur à combustion interne pour l'industrie automobile, par exemple.

## Revendications

1. Boîtier pour circuit électronique comprenant au moins un composant électronique de puissance (10, 11, 12), muni d'au moins un radiateur (13, 13′) présentant une (15) surface agencée pour être en contact thermique et électrique avec l'électrode de puissance du composant, caractérisé en ce que ladite surface du radiateur affleure sur une face d'une paroi interne du boîtier alors que les autres faces du radiateur sont noyées dans cette paroi, et en ce qu'une broche de connexion électrique (14) est formée d'une pièce avec le radiateur, cette broche s'étendant dans l'épaisseur d'au moins ladite paroi du boîtier pour sortir de celui-ci dans une position de connexion extérieure (5).

2. Boîtier selon la revendication 1, caractérisé en ce que le radiateur (13) prend la forme d'une plaquette pleine.

3. Boîtier selon la revendication 1, caractérisé en ce que le radiateur prend la forme d'une plaquette ajourée (13″, 13‴).

4. Boîtier selon l'une quelconque des revendications 1 à 3, caractérisé en ce que le radiateur présente des enfoncements.

5. Boîtier selon l'une quelconque des revendications 1 à 4, caractérisé en ce que la matière de ses parois est une résine thermoplastique ou thermodurcisable surmoulée sur le radiateur de manière à dégager la surface (15) du radiateur qui reçoit l'électrode de puissance du composant électronique.

6. Boîtier selon l'une quelconque des renvendications précédentes, caractérisé en ce que la surface du radiateur qui reçoit la dite électrode du composant de puissance est métallisée pour faciliter la soudure de cette électrode.

7. Boîtier selon l'une quelconque des revendications précédentes, caractérisé en ce qu'il comprend plusieurs desdits radiateurs à broche de connexion intégrée partiellement noyés dans la matière du boîtier, les extrémités (5) des dites broches étant ordonnées sur au moins une face externe (3) du boîtier.

8. Boîtier selon l'une quelconque des revendications précédentes, caractérisé en ce qu'il comprend un substrat accolé à la paroi interne du boîtier sur laquelle affleure le ou les radiateurs et dégageant au moins une partie des surfaces affleurantes de ces radiateurs pour la fixation sur ces parties desdites électrodes de puissance des composants de puissance, ce substrat recevant d'autres composants actifs (9) ou passifs (8) et leurs connexions, y compris à des broches de connexion extérieures (5′) ordonnées avec celles (5) qui sont solidaires des radiateurs.

9. Boîtier selon la revendication 8, caractérisé en ce que le substrat est découpé d'au moins une fenêtre qui reçoit, dans l'épaisseur du substrat, un composant électronique (12) connecté en liaison directe à des conducteurs (19) formés sur la face découverte du substrat.

## Claims

1. Housing for an electronic circuit comprising at least one electronic power component (10, 11, 12), equipped with at least one metallic radiator (13, 13′) exhibiting a surface (15) arranged to be in thermal and electrical contact with the power electrode of the component, characterised in that said surface of the radiator is flush on a face of an internal wall of the housing, while the other faces of the radiator are embedded in this wall, and in that an electrical connecting pin (14) is formed in one piece with the radiator, this pin extending in the thickness of at least said wall of the housing, to emerge from the latter in an external connecting position (5).

2. Housing according to Claim 1, characterised in that the radiator (13) takes the form of a solid plate.

3. Housing according to Claim 1, characterised in that the radiator takes the form of an apertured plate (13″, 13‴).

4. Housing according to any one of Claims 1 to 3, characterised in that the radiator exhibits indentations.

5. Housing according to any one of Claims 1 to 4, characterised in that the material of its walls is a thermoplastic or thermosetting resin moulded onto the radiator in such a manner as to release the surface (15) of the radiator which receives the power electrode of the electronic component.

6. Housing according to any one of the preceding claims, characterised in that the surface of the radiator which receives said electrode of the power component is metallised in order to facilitate the welding of this electrode.

7. Housing according to any one of the preceding claims, characterised in that it comprise a plurality of the said radiators having an integrated connecting pin which are partially embedded in the material of the housing, the ends (5) of said pins being ordered on at least one external face (3) of the housing.

8. Housing according to any one of the preceding claims, characterised in that it comprises a substrate attached to the internal wall of the housing, on which internal wall the radiator or radiators are flush, and releasing at least a part of the flush surfaces of these radiators for the fixing on these parts of the said power electrodes of the power components, this substrate receiving other active (9) or passive (8) components and their connections, including at external connecting pins (5′) which are ordered with those (5) which are integral with the radiators.

9. Housing according to Claim 8, characterised in that the substrate is cut out with at least one window which receives, in the thickness of the substrate, an electronic component (12) connected in direct linkage to conductors (19) formed on the uncovered face of the substrate.


**Patentansprüche**

1. Gehäuse für eine elektronische Schaltung mit mindestens einer elektronischen Leistungskomponente (10, 11, 12), die mit mindestens einem metallischen Strahler (13, 13′) mit einer Fläche (15) versehen ist, die in thermischer und elektrischer Berührung mit der Leistungselektrode der Komponente steht, dadurch gekennzeichnet, daß die besagte Fläche des Strahlers mit einer Seitenfläche einer Innenwand des Gehäuses fluchtet, während die anderen Flächen des Strahlers in dieser Wand versenkt sind, und daß eine elektrische Kontaktlamelle (14) einstückig mit dem Strahler ausgebildet ist, wobei diese Lamelle im Inneren mindestens der besagten Gehäusewand verläuft, um aus dieser in eine äußere Kontaktposition (5) vorzustehen.

2. Gehäuse nach Anspruch 1, dadurch gekennzeichnet, daß der Strahler (13) als volle Scheibe ausgebildet ist.

3. Gehäuse nach Anspruch 1, dadurch gekennzeichnet, daß der Strahler als durchbrochene Scheibe (13″, 13‴) ausgebildet ist.

4. Gehäuse nach einem der Ansprüche 1 bis 3, dadurch gekennzeichnet, daß der Strahler Vertiefungen aufweist.

5. Gehäuse nach einem der Ansprüche 1 bis 4, dadurch gekennzeichnet, daß das Material seiner Wände ein thermoplastisches oder wärmehärtbares Kunstharz ist, das um den Strahler so gegossen ist, daß die die Leistungselektrode der elektronischen Komponente aufnehmende Fläche (15) des Strahlers freibleibt.

6. Gehäuse nach einem der vorhergehenden Ansprüche, dadurch gekennzeichnet, daß die die Elektrode der Leistungskomponente aufnehmende Fläche des Strahlers zum leichteren Verschweißen der Elektrode metallisiert ist.

7. Gehäuse nach einem der vorhergehenden Ansprüche, dadurch gekennzeichnet, daß es mehrere derartiger im Material des Gehäuses teilweise versenkter Strahler mit integrierter Kontaktlamelle aufweist, wobei die Enden (5) der Lamellen auf mindestens einer Außenfläche (3) des Gehäues verteilt angeordnet sind.

8. Gehäuse nach einem der vorhergehenden Ansprüche, dadurch gekennzeichnet, daß es ein Substrat aufweist, das an der Gehäusewand, mit der der oder die Strahler fluchten, anliegt und mindestens einen Abschnitt der flutenden Flächen dieser Strahler freiläßt, um an diesen Abschnitten der Leistungselektroden der Leistungskomponenten befestigt zu werden, wobei das Substrat weitere aktive (9) oder passive (8) Komponenten sowie ihre Verbindungen einschließlich äußerer Kontaktlamellen (5′) aufnimmt, die mit den Kontaktlamellen (5) der Strahler verteilt angeordnet sind.

9. Gehäuse nach Anspruch 8, dadurch gekennzeichnet, daß in dem Substrat ein Fenster ausgeschnitten ist, das in der Dicke des Substrats eine elektronische Komponente (12) aufnimmt, die direkt mit Leitern (19) auf der freiliegenden Fläche des Substrats verbunden ist.

FIG_1

## FIG_2

## FIG_3